# EUROPÄISCHE PATENTANMELDUNG

(11) **EP 4 362 238 A1**
(43) Veröffentlichungstag der Anmeldung: **01.05.2024**
(21) Anmeldenummer: 23205087.2
(22) Anmeldetag: 23.10.2023
(51) Int. Cl.: H01R 13/533

(54) **KONTAKTBAUGRUPPE FÜR EINEN ELEKTRISCHEN STECKVERBINDER MIT EINEM AN EINEM KONTAKTELEMENT ANGEORDNETEN WÄRMEKAPAZITÄTSELEMENT**

(30) Priorität: 24.10.2022 BE 202205856
(71) Anmelder: Phoenix Contact e-Mobility GmbH, 32816 Schieder-Schwalenberg (DE)
(72) Erfinder: FÜHRER, Thomas, 32825 Blomberg (DE)
(74) Vertreter: Meyer-Graefe, Karsten

(57) **Zusammenfassung**

Ein Kontaktbaugruppe für einen elektrischen Steckverbinder (100, 100'), aufweisend:
zumindest ein Kontaktelement (3, 3A', 3B') mit einem ersten Endbereich (31, 31A', 31B'), der zum Verbinden mit einem korrespondierenden Steckverbinder ausgebildet ist und einem dem ersten Endbereich (31, 31A', 31 B') abgewandten zweiten Endbereich (33, 33A', 33B'), der zum Verbinden mit einer Lastleitung (200, 200A', 200B') ausgebildet ist;
ein Wärmekapazitätselement (7, 7'), das zumindest bereichsweise an dem zumindest einen Kontaktelement (3, 3A', 3B`) anordenbar ist; und
ein Isolationsmaterial (5, 5'), das in einem Bereich zwischen dem Wärmekapazitätselement (7, 7') und dem zumindest einen Kontaktelement (3, 3A', 3B`) anordenbar ist, zum elektrischen Isolieren des Wärmekapazitätselements (7, 7') von dem zumindest einen Kontaktelement (3, 3A', 3B').

Weiterhin schlägt die Erfindung einen elektrischer Steckverbinder, insbesondere einen Ladesteckverbinder einer Ladeeinrichtung zum Laden eines Elektrofahrzeugs vor.

## Beschreibung

Die Erfindung betrifft eine Kontaktbaugruppe für einen elektrischen Steckverbinder und einen elektrischen Steckverbinder, insbesondere einen Ladesteckverbinder einer Ladeeinrichtung zum Laden eines Elektrofahrzeugs.

Eine derartige Kontaktbaugruppe für einen elektrischen Steckverbinder weist ein Kontaktelement mit einem ersten Endbereich auf, der zum Verbinden mit einem korrespondierenden Steckverbinder ausgebildet ist. Das Kontaktelement weist einen dem ersten Endbereich abgewandten zweiten Endbereich auf, der verbindbar mit einer Lastleitung ausgebildet ist. Die Kontaktbaugruppe weist ein Wärmekapazitätselement auf, das zumindest bereichsweise an dem zumindest einen Kontaktelement anordenbar ist.

Insbesondere im Bereich der E-Mobilität bestehen für Steckverbinder und damit verbundene Leitungssätze hohe Anforderungen hinsichtlich der Stromtragfähigkeit und der damit verbundenen thermischen Belastungen. Neben den Kabeln sind die Steckverbinder regelmäßig hohen Ladeströmen, z.B. von 800 Ampere und mehr ausgesetzt. Diese hohen Ströme sollen mit möglichst geringer Verlustleistung übertragen werden. Die Verlustleistung steigt quadratisch mit dem Strom.

Für ein Schnellladen mit Gleichstrom betragen die Ladezeiten oftmals zwischen 10 und 30 Minuten, wobei sich diese Ladezeiten zukünftig weiter verkürzen sollen. Die Aufheizkurven sind aufgrund der großen Massen der stromführenden Teile derart ausgeprägt, dass sich die Gleichgewichtstemperatur auch bei höheren Strömen teilweise erst nach mehreren Minuten einstellt. Normativ ist hierzu festgelegt, dass zu jedem Zeitpunkt des Ladens kein Bauteil innerhalb der Steckverbindung eine Temperaturerhöhung von mehr als 50 Kelvin erfahren darf. Wegen der normativen Definition der Steckverbinder im Bereich der E-Mobilität, ist es nicht möglich die Geometrien der Kontaktelemente zu skalieren, um damit eine größere Stromtragfähigkeit und eine geringere Temperaturerhöhung zu realisieren. Vielmehr soll mit den bestehenden genormten Steckverbinder-Geometrien größtmögliche Leistungsübertragungen erreicht werden und gleichzeitig die entstehende Stromwärme im Steckverbinder kontrollierbar gemacht werden.

Dies wird bislang oft erfolgreich mit aktiv gekühlten Steckverbindern und Ladekabeln erreicht. Der technische Aufwand, der hierfür in der Regel betrieben werden muss, spiegelt sich aber in den Kosten und dem Aufwand für die Herstellung der aktiv gekühlten Komponenten der entsprechenden Ladeeinrichtungen wider. Die DE 10 2016 107 409 A1 schlägt beispielsweise einen Steckverbinder mit einer aktiven Kühlung vor.

Die Dokumente DE 10 2016 105 308 A1 und US 10 535 940 B2 beschreiben Kontaktbaugruppen mit Kontaktelementen, an denen Wärmekapazitätselemente angeordnet sind. Diese Wärmekapazitätselemente sind, wie im Stand der Technik üblich, thermisch und auch elektrisch leitend mit den Kontaktelementen verbunden.

Die Wärmekapazitätselemente sind oftmals aus Materialien ausgebildet, die sowohl thermisch als auch elektrisch leitfähig sind. Oftmals werden hierfür Metalle oder graphitbasierende Werkstoffe verwendet.

Allerdings ist die Anbindung der aus dem Stand der Technik bekannten Wärmekapazitätselemente an die Kontaktelemente oftmals komplex, da die verwendeten Wärmekapazitätselemente oft Bestandteil des Strompfades sind und gegen benachbarte Komponenten, wie beispielsweise benachbarte Wärmekapazitätselemente an benachbarten Kontaktelementen, elektrisch isoliert werden müssen.

Aufgabe der vorliegenden Erfindung ist es, eine Kontaktbaugruppe bereitzustellen, bei der über ein Wärmekapazitätselement an einem Kontaktelement eine möglichst große Wärmemenge, die durch einen Stromfluss durch das Kontaktelement entsteht, abgeführt werden kann und die dabei einen einfachen und platzsparenden Aufbau ermöglicht.

Diese Aufgabe wird durch einen Gegenstand mit den Merkmalen des Anspruchs 1 gelöst.

Demnach weist die Kontaktbaugruppe für einen elektrischen Steckverbinder zumindest ein Kontaktelement auf mit einem ersten Endbereich, der zum Verbinden mit einem korrespondierenden Steckverbinder ausgebildet ist und einem dem ersten Endbereich abgewandten zweiten Endbereich, der zum Verbinden mit einer Lastleitung ausgebildet ist. Auch weist die Kontaktbaugruppe ein Wärmekapazitätselement auf, das zumindest bereichsweise an dem zumindest einen Kontaktelement anordenbar ist. Weiterhin weist die Kontaktbaugruppe ein Isolationsmaterial auf, das in einem Bereich zwischen dem Wärmekapazitätselement und dem zumindest einen Kontaktelement anordenbar ist, zum elektrischen Isolieren des Wärmekapazitätselements von dem zumindest einen Kontaktelement.

Bei der Kontaktbaugruppe wird das Wärmekapazitätselement an dem zumindest einen Kontaktelement angeordnet, indem das Wärmekapazitätselement indirekt mit einer durch das Isolationsmaterial gebildeten Zwischenlage an dem zugeordneten, zumindest einen Kontaktelement angeordnet und darüber mit dem Kontaktelement in Verbindung gebracht wird. In montierter Stellung nimmt das Isolationsmaterial somit eine Zwischenlage zwischen dem Kontaktelement und dem Wärmekapazitätselement ein, sodass das Wärmekapazitätselement über das Isolationsmaterial thermisch mit dem Kontaktelement gekoppelt ist, dabei aber elektrisch von dem Kontaktelement isoliert ist.

Das zumindest eine Kontaktelement kann einteilig oder mehrteilig aus einem leitfähigen Material ausgebildet sein und zumindest bereichsweise einen zylindrischen Querschnitt aufweisen. Der erste Endbereich kann als Kontaktstift oder als Kontaktbuchse ausgebildet sein, zum Verbinden mit einer korrespondierenden Kontaktbuchse oder einem korrespondierenden Kontaktstift eines korrespondierenden Steckverbinders. Der zweite Endbereich kann eine Aufnahme aufweisen, an die eine als Lastleitung ausgebildete elektrische Leitung angeschlossen werden kann. Beispielsweise kann das Kontaktelement ausgebildet sein, elektrische Ströme von größer 300 A, beispielsweise von bis zu 800 A zu übertragen.

Zum Anordnen des Wärmekapazitätselements an dem Kontaktelement, kann das Wärmekapazitätselement eine Verbindungsfläche aufweisen, die im Wesentlichen korrespondierend ausgestaltet sein kann zu einer Verbindungsfläche des Kontaktelements, die sich zumindest bereichsweise zwischen dem ersten Endbereich und dem zweiten Endbereich des Kontaktelements erstreckt. Das Wärmekapazitätselement kann beispielsweise mittels eines Halteelements, beispielsweise einem federnden Spannelement oder einem Klemmteil, an dem Kontaktelement gehalten werden. Das Wärmekapazitätselement kann blockförmig und einteilig aus einem Metall oder einem graphitbasierenden Material ausgebildet sein. Das Wärmekapazitätselement kann ein Phasenwechselmaterial aufweisen oder aus einem solchen ausgebildet sein. Das Wärmekapazitätselement kann aus einem einzigen Material oder auch aus mehreren unterschiedlichen Materialien ausgebildet sein. Das Wärmekapazitätselement ist ausgestaltet Wärme von dem Kontaktelement aufzunehmen. Das Wärmekapazitätselement ist thermisch über das Isolationsmaterial mit dem Kontaktelement verbunden, sodass Wärme von dem Kontaktelement in das Wärmekapazitätselement einströmen und dort aufgenommen werden kann. Dies geht von dem Gedanken aus, an einem elektrischen Steckverbinder eine vergrößerte Wärmekapazität bereitzustellen, aufgrund derer das Erwärmen des elektrischen Steckverbinders, insbesondere des Kontaktelements des elektrischen Steckverbinders, zumindest verlangsamt werden kann. Dies kann beispielsweise bei einem elektrischen Steckverbinder für eine Ladeeinrichtung zum Laden eines Elektrofahrzeugs sinnvoll sein und wirkungsvoll ein übermäßiges Erwärmen an einer solchen Ladeeinrichtung verhindern.

Die Kontaktbaugruppe weist ein Isolationsmaterial auf, das in einem Bereich zwischen dem Wärmekapazitätselement und dem zumindest einen Kontaktelement anordenbar und zum elektrischen Isolieren des Wärmekapazitätselements von dem zumindest einen Kontaktelement bei dennoch wirkungsvoller thermischer Kopplung ausgestaltet ist. Das Isolationsmaterial liegt vorzugsweise vollflächig zwischen dem Kontaktelement und dem Wärmekapazitätselement ein, so dass das Kontaktelement und das Wärmekapazitätselement sich nicht direkt berühren und durch das Isolationsmaterial elektrisch gegeneinander isoliert sind.

In einer montierten Stellung ist das Wärmekapazitätselement zumindest bereichsweise an dem zumindest einen Kontaktelement angeordnet und das Isolationsmaterial ist in einem Bereich zwischen dem Wärmekapazitätselement und dem zumindest einen Kontaktelement angeordnet, zum elektrischen Isolieren des Wärmekapazitätselements von dem zumindest einen Kontaktelement.

Das Isolationsmaterial ist elektrisch isolierend, aber thermisch leitfähig ausgestaltet. Hierfür weist das Isolationsmaterial vorzugsweise einen hinreichend hohen elektrischen Widerstand und einen hinreichend niedrigen thermischen Widerstand auf. Vorteilhaft kann durch die Anordnung des Wärmekapazitätselements mittels eines Isolationsmaterials auf dem Kontaktelement entstehende Wärme gut abgeführt werden, bei zuverlässiger, durchschlagfester elektrischer Isolierung des Wärmekapazitätselements von dem zugeordneten Kontaktelement.

In einer Ausgestaltung weist die Kontaktbaugruppe zumindest zwei Kontaktelemente auf, wobei das Wärmekapazitätselement gemeinsam an den zumindest zwei Kontaktelementen anordenbar ist und das Isolationsmaterial an den zumindest zwei Kontaktelementen zwischen dem Wärmekapazitätselement und den zumindest zwei Kontaktelementen anzuordnen ist. In montierter Stellung liegt das Wärmekapazitätselement gemeinsam an den Kontaktelementen an, unter Zwischenlage des Isolationsmaterials, das das Wärmekapazitätselement elektrisch von den Kontaktelementen trennt, thermisch aber mit den Kontaktelementen verbindet. Beispielsweise kann sich eine Fläche des Isolationsmaterials über zwei benachbarte Kontaktelemente erstrecken, und ein einteilig oder einstückig ausgebildetes Wärmekapazitätselement kann auf den beiden Kontaktelementen angeordnet werden.

Durch die elektrische Isolation des Wärmekapazitätselements von den Kontaktelementen über das Isolationsmaterial kann ein einziges Wärmekapazitätselement zusammen mit zumindest zwei Kontaktelementen verwendet werden. Der Einsatz von zwei getrennten Wärmekapazitätselementen, welche wiederum elektrisch gegeneinander isoliert werden müssten, kann hierdurch entfallen. Auf diese Weise kann ein kompakter Aufbau erzielt werden, bei guter Wärmeaufnahme und -abfuhr über das Wärmekapazitätselement.

In einer Ausgestaltung ist das Isolationsmaterial als Folie, insbesondere als Polyimidfolie, ausgebildet, wobei die Folie eine Materialstärke in einem Bereich von 0,01 mm bis 0,1 mm, insbesondere in einem Bereich von 0,02 mm bis 0,08 mm aufweist.

Eine solche Folie kann einfach verarbeitet werden und als Zwischenlage zwischen dem zumindest einen Kontaktelement und dem Wärmekapazitätselement anordenbar sein. Durch das hohe elektrische Isolationsvermögen einer solchen Folie kann ihre Stärke so klein gewählt werden, dass ihr thermischer Widerstand gering ist. Insbesondere können durch eine solche Folie Materialstärken von wenigen hundertstel Millimeter realisiert werden, bei gleichzeitiger elektrischer Spannungsfestigkeit von einigen Kilovolt. Die Folie kann gegebenenfalls mit zumindest einer funktionalen Beschichtung versehen werden, um eine verbesserte Anpassung an ihren Anwendungszweck zu erreichen.

In einer Ausgestaltung weist das Isolationsmaterial eine Wärmeleitfähigkeit in einem Bereich von 0,1 W/(mK) bis 0,3 W/(mK), insbesondere von 0,2 W/(mK) auf.

In einer Ausgestaltung weist die Folie zumindest eine Klebeschicht auf, wobei die Klebeschicht auf zumindest einer Seite der Folie, insbesondere vollflächig, angeordnet ist. Vorteilhaft kann durch ein Aufkleben der Folien auf das zumindest eine Kontaktelement und/oder das Wärmekapazitätselement der Wärmeübergangskoeffizient verbessert werden.

In einer Ausgestaltung ist die Folie schlauchförmig ausgebildet und erstreckt sich zumindest bereichsweise um das zumindest eine Kontaktelement herum. Durch die schlauchförmig ausgebildete Folie können einfach und zuverlässig auch Wärmekapazitätselemente mit nicht flach ausgebildeten Verbindungsflächen, beispielsweise mit zylindrischen Verbindungsflächen, elektrisch isoliert werden.

In einer Ausgestaltung ist das Isolationsmaterial schichtförmig ausgebildet mit einer Wärmeleitfähigkeit von bis zu 5 W/(mK), und weist insbesondere ein Silikonkautschukmaterial auf. Beispielsweise kann das Isolationsmaterial als ein Zuschnitt aus einem Flachmaterial ausgebildet sein. Vorteilhaft kann mit einem Silikonkautschukmaterial eine Wärmeleitfähigkeit von bis zu 5 W/(mK) erreicht werden.

In einer Ausgestaltung ist das Isolationsmaterial als Spritzgussteil aus einem wärmeleitenden thermoplastischen Kunststoffmaterial ausgebildet. Vorteilhaft kann das Spritzgussteil mit einer beliebigen Kontur ausgebildet werden, wie beispielsweise flach, rohrförmig oder als sonstige dreidimensionale Struktur.

In einer Ausgestaltung ist das Isolationsmaterial als Beschichtung, insbesondere als Lackierung oder Pulverbeschichtung, zwischen den zumindest zwei Kontaktelementen und dem Wärmekapazitätselement angeordnet. Das Isolationsmaterial kann hierbei auf das zumindest eine Kontaktelement und/oder das Wärmekapazitätselement aufgebracht sein. Durch eine Beschichtung können sehr dünne Schichten realisiert werden, und auch Elemente mit komplexen Geometrien können zuverlässig elektrisch voneinander isoliert werden.

In einer Ausgestaltung weist die Kontaktbaugruppe ein Halteelement auf, das zumindest bereichsweise an dem Wärmekapazitätselement und dem zumindest einen Kontaktelement anordenbar ist und angepasst ist zum Halten des Wärmekapazitätselements an dem zumindest einen Kontaktelement. Das Halteelement kann beispielsweise in einer montierten Stellung bandförmig um das zumindest eine Kontaktelement und das Wärmekapazitätselement herum erstreckt sein. Das Halteelement kann beispielsweise aus einem elastisch federnden Material gefertigt sein und das Wärmekapazitätselement so mit dem zumindest einen Kontaktelement verspannen, dass das Wärmekapazitätselement unter elastischer Vorspannung an dem zumindest einen Kontaktelement anliegt.

Das Halteelement kann somit als Spannmittel dienen und durch Bereitstellung einer hinreichenden Spannkraft eine dauerhafte Verbindung von Kontaktelement und Wärmekapazitätselement ermöglichen. Hierdurch kann das Wärmekapazitätselement einen festen Sitz an dem Kontaktelement einnehmen. Weiterhin kann durch die Kraftbeaufschlagung des Wärmekapazitätselements ein fester Sitz selbst bei von außen einwirkenden Vibrationen gewährleistet werden.

In einer Ausgestaltung weist das zumindest eine Kontaktelement eine an dem zweiten Endbereich geformte, erste Verbindungsfläche auf, und das Wärmekapazitätselement weist eine mit der ersten Verbindungsfläche korrespondierende, zweite Verbindungsfläche auf, wobei das Isolationsmaterial zwischen der ersten Verbindungsfläche und der zweiten Verbindungsfläche anordenbar ist. Vorteilhaft kann durch zueinander korrespondierend ausgestaltete Verbindungsflächen eine stabile Verbindung zwischen dem zumindest einen Kontaktelement und dem Wärmekapazitätselement geschaffen werden. Insbesondere kann die erste Verbindungsfläche komplementär zur zweiten Verbindungsfläche geformt sein, sodass die erste Verbindungsfläche und die zweite Verbindungsfläche - unter Zwischenlage des Isolationsmaterials - flächig aneinander anliegen können.

In einer Ausgestaltung sind die erste Verbindungsfläche und die zweite Verbindungsfläche flach oder gekrümmt ausgebildet.

In einer Ausgestaltung sind die erste Verbindungsfläche und die zweite Verbindungsfläche zylindrisch ausgebildet, wobei das zumindest eine Kontaktelement mit einem zweiten Endbereich in einer Öffnung des Wärmekapazitätselement einliegt.

In einer Ausgestaltung ist das Isolationsmaterial durch ein wannenförmiges Element mit einer Basis und an der Basis erstreckten Schenkeln ausgebildet. Mit den Schenkeln kann das wannenförmige Element insbesondere Kanten des Wärmekapazitätselements umgreifen und sich somit in einen Bereich des Wärmekapazitätselements erstrecken, der nicht (unmittelbar) dem zugeordneten Kontaktelement zugewandt ist. Durch die wannenförmige Ausgestaltung kann ein Isolationsabstand vergrößert und die Durchschlagfestigkeit, insbesondere gegen einen Flächendurchschlag, verbessert sein.

In einer Ausgestaltung weist das Wärmekapazitätselement ein Phasenwechselmaterial und/oder ein Metall, insbesondere Kupfer oder Aluminium, auf.

Das Wärmekapazitätselement kann aus einem metallenen Werkstoff, beispielsweise aus Kupfer oder Aluminium, hergestellt sein, um eine große Wärmekapazität und eine gute Wärmeleitfähigkeit zu erhalten.

Alternativ kann das Wärmekapazitätselement auch aus einem Phasenwechselmaterial hergestellt sein oder ein Phasenwechselmaterial aufweisen. Unter einem Phasenwechselmaterial wird hierin ein Material verstanden, das bei einem Phasenwechsel von fest zu flüssig große Mengen Wärme bei konstanter Temperatur und vergleichsweise kleinen Volumina speichern kann. Beispielsweise kann das Phasenwechselmaterial aus einem Materialverbund aus Graphit und Paraffin bestehen.

Durch den Einsatz eines Phasenwechselmaterials kann eine hohe volumenbezogene Energiespeicherdichte erreicht werden.

In einer Ausgestaltung weist das Wärmekapazitätselement einen massiven, quaderförmigen Körper auf.

Vorteilhaft kann durch eine derartige Ausgestaltung eine große Wärmekapazität erreicht werden. Weiter vorteilhaft können In einer Ausgestaltung an dem Wärmekapazitätselement auch Kühlrippen angeordnet sein, über die Wärme an die Umgebung abgegeben werden kann.

Weiterhin bezieht sich die Erfindung auf einen elektrischen Steckverbinder, insbesondere einen Ladesteckverbinder einer Ladeeinrichtung zum Laden eines Elektrofahrzeugs, aufweisend zumindest eine hierin beschriebene Kontaktbaugruppe.

In einer Ausgestaltung weist der elektrische Steckverbinder zwei Kontaktbaugruppen mit jeweils einem Kontaktelement und einem Wärmekapazitätselement auf. In einer anderen Ausgestaltung weist der elektrische Steckverbinder eine Kontaktbaugruppe mit zwei Kontaktelementen und einem den Kontaktelementen gemeinsam zugeordneten Wärmekapazitätselement auf.

Der der Erfindung zugrunde liegende Gedanke soll nachfolgend anhand der in den Figuren dargestellten Ausführungsformen näher erläutert werden. Es zeigen:
- Figuren 1A, 1B: schematische Ansichten einer Kontaktbaugruppe gemäß einer ersten Ausführungsform;
- Figuren 2A, 2B: schematische Ansichten eines Kontaktbaugruppe gemäß einer zweiten Ausführungsform;
- Figuren 3A - 3D: schematische Schnittansichten durch Verbindungsflächen gemäß Ausführungsformen der Erfindung; und
- Figuren 4A - 4D: schematische Ansichten eines elektrischen Steckverbinders nach Ausführungsformen der Erfindung.

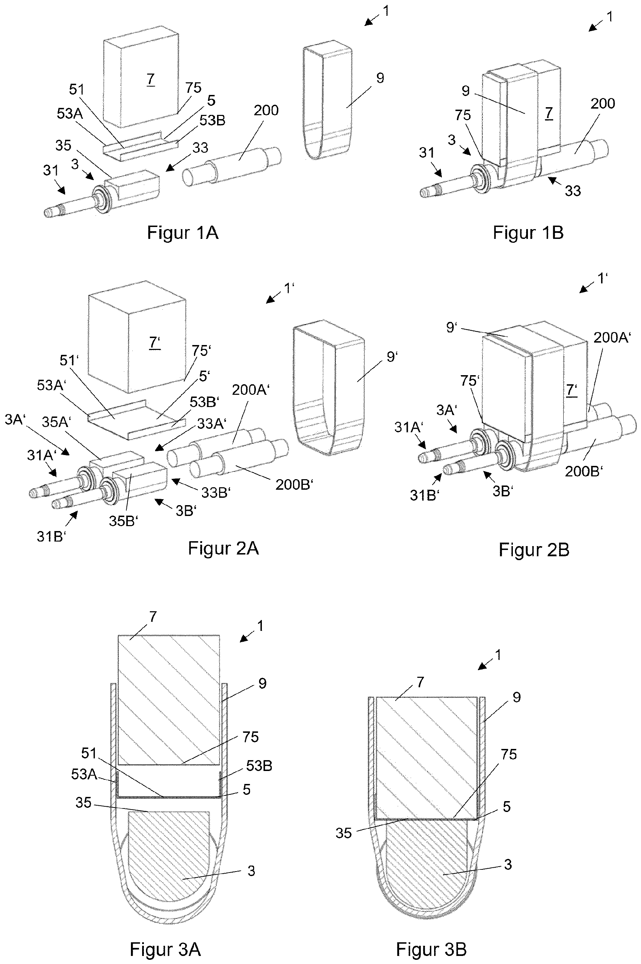

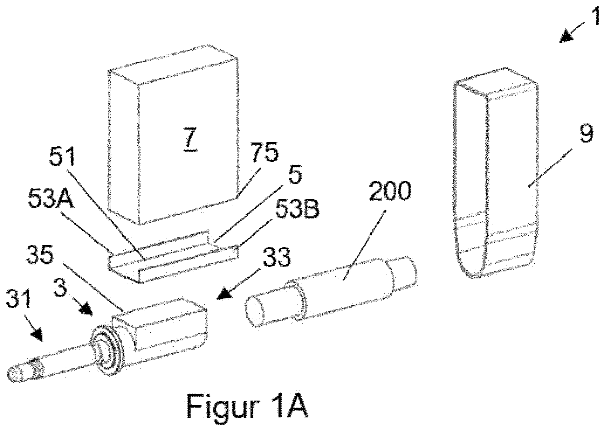

Die Figur 1A zeigt eine Explosionsansicht einer Kontaktbaugruppe 1, d.h. vor dem Anordnen des Wärmekapazitätselements 7 an dem Kontaktelement 3, gemäß einer ersten Ausführungsform. Das gezeigte Kontaktelement 3 ist als Stiftkontakt ausgebildet und weist einen ersten Endbereich 31 auf, zum Verbinden mit einer korrespondierenden Buchse eines korrespondierenden Steckverbinders (nicht gezeigt). Der dem ersten Endbereich 31 abgewandte zweite Endbereich 33 ist verbindbar mit einer Lastleitung 200.

In der gezeigten Ausführungsform weist das Kontaktelement 3 zwischen dem ersten Endbereich 31 und dem zweiten Endbereich 33 eine Verbindungsfläche 35 auf, die korrespondierend ausgestaltet ist zu einer Verbindungsfläche 75 des Wärmekapazitätselements 7. Unterschiedliche Ausführungsformen für korrespondierende Verbindungsflächen sind in den Figuren 3A-3D gezeigt.

Weiterhin ist in der in den Figuren 1A und 1B gezeigten Ausführungsform das Isolationsmaterial 5 zwischen dem Wärmekapazitätselement 7 und dem Kontaktelement 3 anordenbar, zum elektrischen Isolieren des Wärmekapazitätselements 7 von dem zumindest einen Kontaktelement 3. In der in Figur 1B gezeigten montierten Stellung der Kontaktbaugruppe 1 steht eine erste Seite des Isolationsmaterials 5 mit der Verbindungsfläche 35 des Kontaktelements 3 in Verbindung, beziehungsweise liegt auf dieser auf, und eine zweite Seite des Isolationsmaterial 5, die der ersten Seite gegenüberliegt, steht mit einer Verbindungsfläche 75 des Wärmekapazitätselements 7 in Verbindung, beziehungsweise liegt auf dieser auf. In der gezeigten Ausführungsform ist das Isolationsmaterial 5 durch ein wannenförmiges Element mit einer Basis 51 und an der Basis 51 erstreckten Schenkeln 53A, 53B ausgebildet, um hierdurch eine Sicherung vor Verrutschen und eine gute Isolation der Randbereiche des Wärmekapazitätselements 7 zu erreichen. In der gezeigten Ausführungsform ist die Basis 51 flach ausgebildet und die beiden Schenkel 53A, 53B schließen jeweils mit der Basis 51 einen rechten Winkel ein. Die Schenkel 53A, 53B verlaufen in der gezeigten Ausführungsform parallel zu den jeweiligen Seitenflächen des blockförmig ausgebildeten Wärmekapazitätselements. In alternativen Ausführungsformen kann das Isolationsmaterial auch Bereiche aufweisen, die in Richtung des Kontaktelements abgewinkelt sind, oder flach, d.h. planar, ausgebildet sind.

In der in den Figuren 1A und 1B gezeigten Ausführungsform ist auch ein Halteelement 9 dargestellt, das zumindest bereichsweise um das Kontaktelement 3 und das Wärmekapazitätselement 7 anordenbar ist, zum Halten des Wärmekapazitätselements 7 an dem Kontaktelement 3. In der gezeigten Ausführungsform ist das Halteelement 9 bandförmig als endlos-Band aus einem elastisch federnden Material ausgestaltet, das über das Wärmekapazitätselement 7 und das Kontaktelement 3 in Verlaufsrichtung des Kontaktelements 3 geschoben werden kann, um das Wärmekapazitätselement 7 mit dem Kontaktelement 3 zu verspannen, sodass das Wärmekapazitätselement 7 unter elastischer Vorspannung an dem zumindest einen Kontaktelement 3 anliegt. In der gezeigten Ausführungsform ist die Geometrie des Halteelements 9 bereits an die zu umgebenden Außenflächen des Wärmekapazitätselements 7 und des Kontaktelements 3 angepasst.

Figur 1B zeigt die Ausführungsform der Kontaktbaugruppe 1 von Figur 1A in montierter Stellung. In montierter Stellung ist das Kontaktelement 3 mit der Lastleitung 200 verbunden und das Wärmekapazitätselement 7 ist an dem Kontaktelement 3 angeordnet. Zwischen dem Wärmekapazitätselement 7 und dem Kontaktelement 3 ist das Isolationsmaterial 5 angeordnet, zum elektrischen Isolieren des Wärmekapazitätselements 7 von dem zumindest einen Kontaktelement 3.

In der Figur 1B ist weiterhin gezeigt, dass das Wärmekapazitätselement 7 über den zweiten Endbereich 33 des Kontaktelements 3 hervorsteht. Hierdurch kann zudem gezielt Wärme an dem Endbereich der Lastleitung 200 aufgenommen und abgeführt werden.

Die Figur 2A zeigt eine Explosionsansicht einer Kontaktbaugruppe 1', d.h. vor dem Anordnen des Wärmekapazitätselements 7' an den Kontaktelementen 3A', 3B', gemäß einer zweiten Ausführungsform.

Die gezeigte Kontaktbaugruppe 1' unterscheidet sich von der zuvor in den Figuren 1A und 1B gezeigten Kontaktbaugruppe 1 dadurch, dass die Kontaktbaugruppe 1' zweipolig ausgeführt ist, d.h. zwei Kontaktelemente 3A', 3B' umfasst. Die gezeigten Kontaktelemente 3A', 3B' sind gleichartig ausgeführt und können dem bereits in den Figuren 1A und 1B dargestellten Kontaktelement 3 entsprechen.

Weiterhin ist gezeigt, dass sich das Isolationsmaterial 5' über die zwei benachbarte Kontaktelemente 3A', 3B' erstreckt. In der gezeigten Ausführungsform erstreckt sich insbesondere die flach ausgebildete Basis 51' über beide Verbindungsflächen 35A', 35B' der Kontaktelemente 3A', 3B'. Hierfür ist das Isolationsmaterial 5' der in den Figuren 2A und 2B dargestellten Ausführungsform breiter ausgebildet als das Isolationsmaterial 5 der in den Figuren 1A und 1B gezeigten Ausführungsform. In der in Figur 2B gezeigten montierten Stellung steht eine erste Seite des Isolationsmaterials 5' mit den beiden Verbindungsflächen 35A', 35B' der Kontaktelemente 3A', 3B' in Verbindung, beziehungsweise liegt auf dieser auf, und eine zweite Seite des Isolationsmaterial 5', die der ersten Seite gegenüberliegt, steht mit der Verbindungsfläche 75' des Wärmekapazitätselements 7' in Verbindung, beziehungsweise liegt auf dieser auf.

Weiterhin ist auch in der in Figur 2B gezeigten Ausführungsform das Halteelement 9 bandförmig als endlos-Band aus einem elastisch federnden Material ausgestaltet und kann über das Wärmekapazitätselement 7' und die Kontaktelemente 3A', 3B' in Verlaufsrichtung der Kontaktelemente 3A', 3B' geschoben werden, um das Wärmekapazitätselement 7' mit den beiden Kontaktelementen 3A', 3B' zu verspannen.

In den Figuren 3A-3D sind Schnittansichten jeweils miteinander korrespondierender Verbindungsflächen 35, 75 gezeigt.

In der Figur 3A ist eine Schnittansicht durch die in der Figur 1A gezeigten Kontaktbaugruppe 1 gezeigt. Im gezeigten Beispiel sind die Verbindungsfläche 35 an dem Kontaktelement 3 und die Verbindungsfläche 75 an dem Wärmekapazitätselement 7 miteinander korrespondierend flach (planar) ausgeführt. Mit den beiden Verbindungsflächen 35, 75 kann jeweils eine Seite des Isolationsmaterials 5 flächig kontaktiert werden, um hierdurch eine gute Wärmeleitfähigkeit zu erreichen. Wie bereits in den Figuren 1A und 1B gezeigt und in der Figur 3A im Detail dargestellt, ist das Isolationsmaterial 5 durch ein wannenförmiges Element mit einer Basis 51 und an der Basis 51 erstreckten Schenkeln 53A, 53B ausgebildet.

In der Figur 3B ist eine Schnittansicht durch die in der Figur 1A gezeigten Kontaktbaugruppe 1 in montierter Stellung gezeigt. Wie in der Figur 3B gezeigt, ist in der dargestellten Ausführungsform das Wärmekapazitätselement 7 mit dem Kontaktelement 3 in montierter Stellung durch das bandförmige Halteelement 9 verspannt.

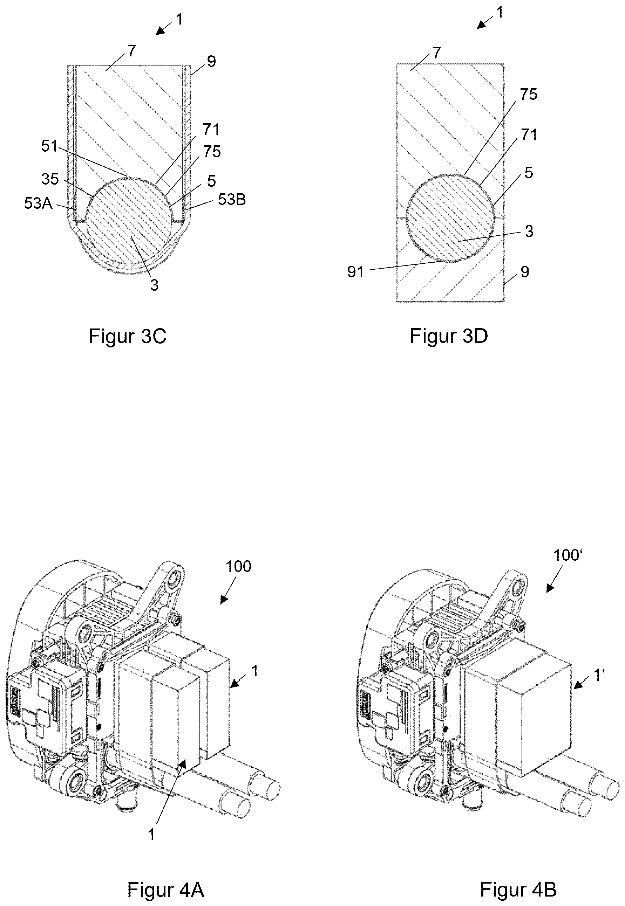

In der Figur 3C ist eine Schnittansicht durch eine Ausführungsform einer Kontaktbaugruppe 1 mit zylindrisch ausgebildeten korrespondierenden Verbindungsflächen 35, 75 gezeigt. In der gezeigten Ausführungsform liegt das Kontaktelement 3 mit dem zweiten Endbereich in einer zylindrisch ausgestalten Öffnung 71 des Wärmekapazitätselements 7 ein. Das Isolationsmaterial 5 ist in der gezeigten Ausführungsform in einem Bereich der Basis 51, der im zusammengebauten Zustand zwischen den zylindrisch ausgestalteten Verbindungsflächen 35, 75 liegt, auch zylindrisch ausgestaltet. Die an der Basis erstreckten Schenkel 53A, 53B verlaufen in der gezeigten Ausführungsform parallel zu den jeweiligen Seitenflächen des Wärmekapazitätselements 7. Weiterhin ist in der Figur 3C ein bandförmiges Halteelement 9 gezeigt, um in der gezeigten Ausführungsform das Wärmekapazitätselement 7 mit dem Kontaktelement 3 zu verspannen.

In der Figur 3D ist eine Schnittansicht durch eine weitere Ausführungsform einer Kontaktbaugruppe 1 gezeigt, die ähnlich der in Figur 3C gezeigten Ausführungsform ausgestaltet ist. Anstelle eines bereichsweise zylindrisch ausgebildeten Isolationsmaterials 5, ist in der in Figur 3D gezeigten Ausführungsform, das Isolationsmaterial 5 als schlauchförmig ausgebildete Folie gezeigt, die sich zumindest um einen Abschnitt des Kontaktelements 3 herum erstreckt. In der in Figur 3C gezeigten Ausführungsform ist das Halteelement 9 als Klemmteil ausgeführt. Das Klemmteil weist, wie bereits das Wärmekapazitätselement 7 in der in Figur 3D gezeigten Ausführungsform, eine zylindrisch ausgestaltete Öffnung 91 auf, sodass das Kontaktelement 3 in der zylindrisch ausgestalteten Öffnung 91 einliegt. In der gezeigten Ausführungsform liegt der zweite Abschnitt des Kontaktelements 3 vollständig zwischen den zylindrisch ausgestalteten Öffnungen 71, 91 des Wärmkapazitätselements 7 und des als Klemmteil ausgeführten Halteelements 9 ein, beziehungsweise ist zwischen dem Wärmekapazitätselement 7 und dem Halteelement 9 eingeklemmt.

In der in Figur 3D gezeigten Ausführungsform ist das Halteelement aus dem gleichen Material, wie bereits, das Wärmekapazitätselement 7 ausgebildet und daher auch ausgestaltet Wärme von dem Kontaktelement 3 aufzunehmen.

Das als Klemmteil ausgestaltete Halteelement 9 ist mittels zumindest eines Verbindungselements mit dem Wärmekapazitätselements verbunden, das in Ausführungsformen als zumindest eine Schraube realisiert ist, die sich durch eine Durchgangsöffnung in dem Material des Halteelements 9 erstreckt, um mit einem entsprechenden Gewinde in einer Öffnung des Wärmekapazitätselements 7 zusammenzuwirken. Das Eindrehen der Schraube verspannt das als Klemmteil ausgeführte Halteelement 9 mit dem Wärmekapazitätselement 7.

Die Figuren 4A bis 4D zeigen schematische Ansichten eines elektrischen Steckverbinders 100, 100' mit Kontaktbaugruppen 1, 1' nach Ausführungsformen der Erfindung. Der Steckverbinder 100, 100' ist als Ladesteckverbinder einer Ladeeinrichtung zum Laden eines Elektrofahrzeugs dargestellt. Im Speziellen ist der Ladesteckverbinder als Combined Charging System, CCS, Stecker, der auch als Combo-Stecker bezeichnet werden kann, dargestellt.

Wie gezeigt, ist der Ladesteckverbinder in zwei Bereiche eingeteilt: Der obere Teil entspricht einem sogenannten Typ-2-Anschluss. Der untere Teil dient für das elektrische Laden mit Gleichstrom.

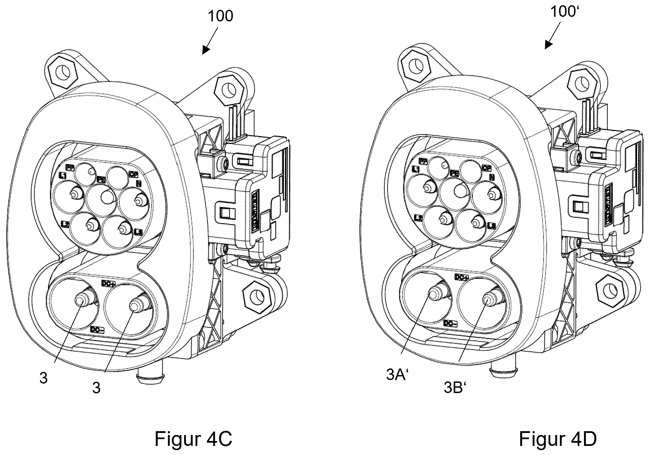

In dem unteren Teil können in der in den Figuren 4A und 4C gezeigten Ausführungsform zwei einpolige Kontaktbaugruppen 1 gemäß der in Figuren 1A, 1B dargestellten Ausführungsform verwendet werden. Alternativ kann in dem unteren Teil, wie in der in den Figuren 4B und 4D dargestellten Ausführungsform gezeigt, eine zweipolige Kontaktbaugruppe 1' gemäß der in den Figuren 2A und 2B dargestellten Ausführungsform verwendet werden.

### Bezugszeichenliste

- 1, 1': Kontaktbaugruppe
- 3, 3A', 3B': Kontaktelement
- 31, 31 A', 31 B': Erster Endbereich
- 33, 33A', 33B': Zweiter Endbereich
- 35, 35A', 35B', 75: Verbindungsfläche
- 5, 5`: Isolationsmaterial
- 51, 51': Basis
- 53A, 53A', 53B, 53B': Schenkel
- 7, 7`: Wärmekapazitätselement
- 71,91: Öffnung
- 9, 9`: Halteelement

- 100, 100': Elektrischer Steckverbinder

- 200, 200A', 200B': Lastleitung

## Patentansprüche

1. Kontaktbaugruppe für einen elektrischen Steckverbinder (100, 100'), aufweisend: zumindest ein Kontaktelement (3, 3A', 3B') mit einem ersten Endbereich (31, 31A', 31B'), der zum Verbinden mit einem korrespondierenden Steckverbinder ausgebildet ist, und einem dem ersten Endbereich (31, 31A', 31B') abgewandten, zweiten Endbereich (33, 33A', 33B'), der zum Verbinden mit einer Lastleitung (200, 200A', 200B') ausgebildet ist, und ein Wärmekapazitätselement (7, 7'), das zumindest bereichsweise an dem zumindest einen Kontaktelement (3, 3A', 3B') anordenbar ist, **gekennzeichnet durch** ein Isolationsmaterial (5, 5'), das in einem Bereich zwischen dem Wärmekapazitätselement (7, 7') und dem zumindest einen Kontaktelement (3, 3A', 3B') anordenbar ist, zum elektrischen Isolieren des Wärmekapazitätselements (7, 7') von dem zumindest einen Kontaktelement (3, 3A', 3B').

2. Kontaktbaugruppe nach Anspruch 1, **gekennzeichnet durch** zumindest zwei Kontaktelemente (3A', 3B'), wobei das Wärmekapazitätselement (7, 7') gemeinsam an den zumindest zwei Kontaktelementen (3A', 3B') anordenbar ist und das Isolationsmaterial (5`) an den zumindest zwei Kontaktelementen (3A', 3B') zwischen dem Wärmekapazitätselement (7, 7') und den zumindest zwei Kontaktelementen (3A', 3B') anordenbar ist.

3. Kontaktbaugruppe nach einem der Ansprüche 1 oder 2, **dadurch gekennzeichnet, dass** das Isolationsmaterial (5, 5') als Folie, insbesondere als Polyimidfolie, ausgebildet ist, wobei die Folie eine Materialstärke in einem Bereich von 0,01 mm bis 0,1 mm, insbesondere in einem Bereich von 0,02 mm bis 0,08 mm aufweist.

4. Kontaktbaugruppe nach Anspruch 3, **dadurch gekennzeichnet, dass** das Isolationsmaterial (5, 5') eine Wärmeleitfähigkeit in einem Bereich von 0,1 W/(mK) bis 0,3 W/(mK), insbesondere von 0,2 W/(mK) aufweist.

5. Kontaktbaugruppe nach einem der Ansprüche 3 oder 4, **dadurch gekennzeichnet, dass** die Folie zumindest eine Klebeschicht aufweist, wobei die Klebeschicht auf zumindest einer Seite der Folie, insbesondere vollflächig, angeordnet ist.

6. Kontaktbaugruppe nach einem der Ansprüche 3 bis 5, **dadurch gekennzeichnet, dass** die Folie schlauchförmig ausgebildet ist und sich zumindest bereichsweise um das zumindest eine Kontaktelement (3, 3A', 3B') erstreckt.

7. Kontaktbaugruppe nach einem der Ansprüche 1 oder 2, **dadurch gekennzeichnet, dass** das Isolationsmaterial (5, 5') schichtförmig ausgebildet ist, insbesondere aufweisend ein Silikonkautschukmaterial, mit einer Wärmeleitfähigkeit von bis zu 5 W/(mK).

8. Kontaktbaugruppe nach einem der Ansprüche 1 oder 2, **dadurch gekennzeichnet, dass** das Isolationsmaterial (5, 5') als Spritzgussteil aus einem wärmeleitenden thermoplastischen Kunststoffmaterial ausgebildet ist.

9. Kontaktbaugruppe nach einem der Ansprüche 1 oder 2, **dadurch gekennzeichnet, dass** das Isolationsmaterial (5, 5') als Beschichtung, insbesondere als Lackierung oder Pulverbeschichtung, zwischen den zumindest zwei Kontaktelementen (3, 3A', 3B') und dem Wärmekapazitätselement (7, 7') angeordnet ist.

10. Kontaktbaugruppe nach einem der vorangehenden Ansprüche, **gekennzeichnet durch** ein Halteelement (9, 9'), das zumindest bereichsweise an dem Wärmekapazitätselement (7, 7') und dem zumindest einen Kontaktelement (3, 3A', 3B') anordenbar ist und angepasst ist zum Halten des Wärmekapazitätselements (7, 7') an dem zumindest einen Kontaktelement (3, 3A', 3B').

11. Kontaktbaugruppe nach Anspruch 10, **dadurch gekennzeichnet, dass** das Haltelement (9, 9') in montierter Stellung bandförmig um das zumindest eine Kontaktelement (3, 3A', 3B') und das Wärmekapazitätselement (7, 7') herum erstreckt ist.

12. Kontaktbaugruppe nach Anspruch 10 oder 11, **dadurch gekennzeichnet, dass** das Haltelement (9, 9') aus einem elastisch federnden Material ausgebildet ist.

13. Kontaktbaugruppe nach einem der vorangehenden Ansprüche, **dadurch gekennzeichnet, dass** das zumindest eine Kontaktelement (3, 3A', 3B') eine an dem zweiten Endbereich (33, 33A', 33B`) geformte, erste Verbindungsfläche (35, 35A', 35B') aufweist und das Wärmekapazitätselement (7, 7') eine mit der ersten Verbindungsfläche (35, 35A', 35B') korrespondierende, zweite Verbindungsfläche (75) aufweist, wobei das Isolationsmaterial (5, 5') zwischen der ersten Verbindungsfläche (35, 35A', 35B') und der zweiten Verbindungsfläche (75) anordenbar ist.

14. Elektrischer Steckverbinder, insbesondere ein Ladesteckverbinder einer Ladeeinrichtung zum Laden eines Elektrofahrzeugs, aufweisend zumindest einen Kontaktbaugruppe (1, 1') nach einem der vorangehenden Ansprüche.
